# EUROPEAN PATENT APPLICATION

(11) **EP 2 258 741 A1**
(43) Date of publication of application: **08.12.2010**
(21) Application number: 10162703.2
(22) Date of filing: 12.05.2010
(51) Int. Cl.: C08G 59/24, C08G 59/32, C08G 59/68, C08L 63/00, C08G 65/18, G02B 1/04, G03F 7/029, G03F 7/031

(54) **Resin composition for optical components and optical component using the same**

(30) Priority: 13.05.2009 JP 2009116727
(71) Applicant: Nitto Denko Corporation, Ibaraki-shi Osaka 567-8680 (JP)
(72) Inventor: Noro, Hiroshi, Ibaraki-shi Osaka (JP); Nakahashi, Akiko, Ibaraki-shi Osaka (JP); Ito, Hisataka, Ibaraki-shi Osaka (JP)
(74) Representative: Grünecker, Kinkeldey, Stockmair & Schwanhäusser Anwaltssozietät

(57) **Abstract**

The present invention relates to a resin composition for optical components, the resin composition being an ultraviolet-curable transparent resin composition to be used as a material for an optical component, in which the resin component includes the following component (A) as a main component and the following component (B) being a photo-cationic polymerization initiator: (A) an epoxy resin having two or more epoxy groups in one molecule thereof; and (B) an onium salt containing a hexafluorophosphate ion as an anion component.

## Description

### FIELD OF THE INVENTION

The present invention relates to a resin composition for optical components and an optical component using the same. More specifically, the invention relates to a resin composition for optical components which is used as a material of an optical lens or a transparent protective plate in an imaging device and the like and is used for adhesion or the like of the optical components, and an optical component using the resin composition,

### BACKGROUND OF THE INVENTION

An imaging device used in a cellular phone, a digital still camera or the like is mounted with an optical lens for imaging. For the optical lens, transparency and high refractive index are required. Heretofore, a lens composed of a glass (mold glass), a thermoplastic resin or the like, an organic-inorganic hybrid lens (hereinafter simply referred to as a "hybrid lens") which is obtained by forming a thermoplastic resin composition into a lens shape on a glass substrate, or the like has been used in the above-described usages. However, since the glass lens is expensive, a thermoplastic resin lens or a hybrid lens is recently predominating (see, Patent Document 1).

On the other hand, in mounting an imaging device using such a lens on a printed board, as methods for connecting these two members (method for mounting the imaging device), a method of effecting the connection using a socket pin or a method of previously soldering an imaging elemental device (a device after removing an optical lens unit from an imaging device) on a substrate and then mounting the optical lens unit is usually employed. Such methods are taken so as to avoid a problem that the thermoplastic resin as a lens material is shape-deformed by the solder reflow step during which heat equal to or higher than the softening point of the resin is exerted.

Patent Document 1: Japanese Patent No. 39263 80

### SUMMARY OF THE INVENTION

However, with recent widespread penetration of a cellular phone with an imaging device, for the purpose of enabling more inexpensive and large-scale production, a system of mounting an imaging device with an optical lens unit en bloc by solder reflow is demanded. The conventional optical lens using a thermoplastic resin as the lens material cannot meet this requirement, because there is a problem that, as described above, the resin deforms due to heat during the solder reflow.

Accordingly, studies are being made on whether an imaging device (with an optical lens unit) can be advantageously mounted en bloc by a reflow system as described above by using a thermosetting resin as the lens material, Also, use of a thermosetting resin not only for a lens but also for a transparent protective plate of an imaging device or for adhesion or the like of such an optical component is being studied.

For example, since a thermosetting silicone resin is transparent and less liable to heat discoloration, its application to the usage described above may be expected. However, since the silicone resin generally exhibits low adherence to glass or the like, it is difficult to apply it, for example, to a hybrid lens or the like. Also, because of its low glass transition temperature and large thermal expansion coefficient, it may be caused in some cases to undergo the thermal contraction due to the usage environment and lower the optical properties. Therefore, its application as a material of an optical lens is difficult.

The present invention has been made under these circumstances, and an object of the invention is to provide a resin composition for optical components exhibiting high adherence to glass or the like and having high transparency and heat resistance reliability (heat discoloration resistance, thermal contraction resistance, etc.) as well as an optical component using the resin composition.

In order to achieve the above-described object, the first aspect of the present invention is an resin composition for optical components which is an ultraviolet-curable transparent resin composition to be used as a material for an optical component, in which the resin component includes the following component (A) as a main component and the following component (B) being a photo-cationic polymerization initiator; and the second aspect thereof is an optical component obtained by using the resin composition of the first aspect:
(A) an epoxy resin having two or more epoxy groups in one molecule thereof; and
(B) an onium salt containing a hexafluorophosphate ion as an anion component.

In order to solve the above-described problems, the present inventors have made intensive studies mainly on ultraviolet-curable resin compositions containing an epoxy resin as a main component which is excellent in adhesiveness to glass or the like, thermal contraction resistance, and the like. As a result, they have found that the desired end state can be achieved, since ultraviolet curability is improved and heat discoloration resistance becomes excellent when the epoxy resin of the component (A) is used as a main component and the onium salt [component (B)] containing a hexafluorophosphate ion as an anion component is used as a photo-cationic polymerization initiator (a photo-acid generator which generates an acid capable of cationic polymerization by ultraviolet irradiation) to be blended as a curing agent thereof. Thus, the invention has been accomplished based on these findings.

As described above, the resin composition for optical components of the invention includes an epoxy resin having two or more epoxy groups in one molecule thereof and also, as a curing agent (photo-acid generator), an onium salt containing a hexafluorophosphate ion as an anion component, and exhibits excellent effects in transparency and heat-resistance reliability (heat discoloration resistance, thermal contraction resistance, etc.). Therefore, the ultraviolet deterioration or the problem of deformation or discoloration due to heat during solder reflow can be overcome. Furthermore, a high-quality hybrid lens can be produced by curing the resin composition on a transparent substrate such as glass to integrate it with the substrate. Moreover, the resin composition has a high adhesive property and thus can be also used for adhesion or the like of an optical component such as an optical lens or a transparent protective plate in an imaging device.

Particularly, when the above-described epoxy resin contains an epoxy resin having a fluorene skeleton, it becomes possible to attain a high refractive index (1.58 or more) and also a sufficient glass transition temperature is obtained.

Moreover, when the above-described epoxy resin contains an alicyclic epoxy resin, the flowability and curability of the resin composition can be further increased.

Furthermore, when the above-described resin composition contains an oxetane compound represented by the following chemical formula (1) or (2) in addition to the above-described epoxy resin and onium salt, the curability (curing rate, mechanical strength, etc.) of the resin composition by an ultraviolet ray can be further increased.

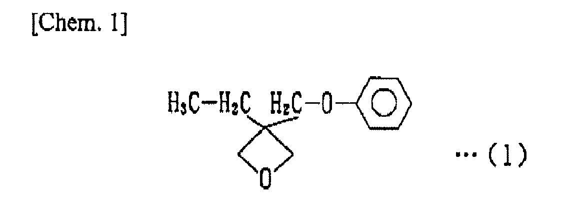

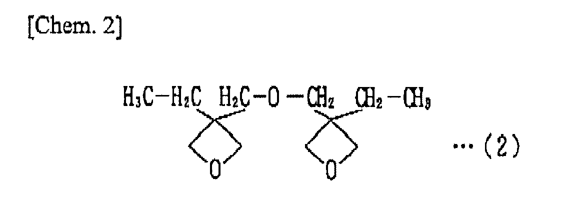

Also, the optical component obtained by using such a resin composition has mechanical properties stable to thermal stress without causing discoloration or deformation due to heat during solder reflow as described above and therefore can be advantageously used when mounting an imaging device en bloc by solder reflow.

### BRIEF DESCRIPTION OF THE DRAWINGS

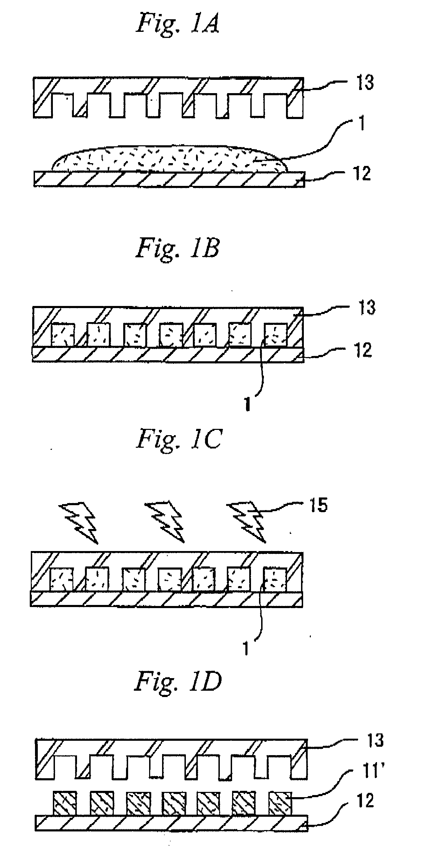

Figs. 1A to 1D are an explanatory view showing the production process of the optical component (optical lens) of the invention: Fig. 1A shows a state of the ultraviolet-curable transparent resin composition being potted on a substrate, Fig. 1B shows a state of the resin composition being filled into a forming mold by pressing the lens shape-forming mold, Fig. 1C shows a state of the filled resin composition under irradiation with an ultraviolet ray, and Fig. 1D shows a state of the optical lens being demolded.

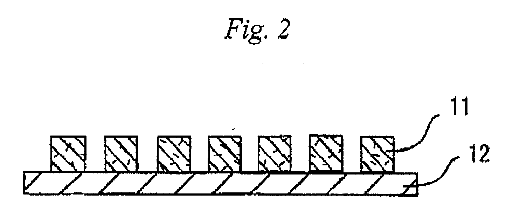

Fig. 2 is a cross-sectional view showing an example of an optical component (optical lens).

### DETAILED DESCRIPTION OF THE INVENTION

Embodiments of the present invention are described in detail bellow.

The resin composition for optical components of the invention is an ultraviolet-curable transparent resin composition to be used as an optical component material and includes the following component (A) as a main component and the following component (B) being a photo-cationic polymerization initiator. Here, the "main component" is a component exerting a large influence on the properties of the composition and usually means a component which accounts for 60% by weight or more based on the total resin composition:
(A) an epoxy resin having two or more epoxy groups in one molecule thereof; and
(B) an onium salt containing a hexafluorophosphate ion as an anion component.

Examples of the epoxy resin of the above-described component (A) include epoxy resins having a fluorene skeleton (fluorene-type epoxy resins), alicyclic epoxy resins, 1,5-hexadiene diepoxide, 1,7-octadiene diepoxide, 1,9-decadiene diepoxide, bisphenol A-type epoxy resin, bisphenol F-type epoxy resin, hydrogenated bisphenol A-type epoxy resin, hydrogenated bisphenol F-type epoxy resin, naphthalene-type epoxy resin, bisphenol S-type epoxy resin, an epoxy resin where hydrogen of such an epoxy resin is partially substituted by a tert-butyl group, a trifluoromethyl group or a fluorine, and a perfluoroepoxy resin of perfluorinated type. These compounds are used alone or in combination thereof.

Among the epoxy resins of the component (A), an epoxy resin having a fluorene skeleton (fluorene-type epoxy resin) is preferably used as an indispensable material since it becomes possible to attain a high refractive index (1.58 or more) and also a sufficient glass transition temperature is obtained.

As the epoxy resin having two or more epoxy groups in one molecule thereof and having a fluorene skeleton as described above, specifically, there may be mentioned an epoxy compound represented by the following chemical formula (3), an epoxy compound represented by the following chemical formula (4), and an epoxy compound represented by the following chemical formula (5), These compounds are used alone or in combination thereof.

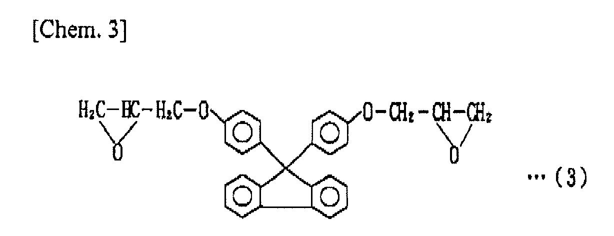

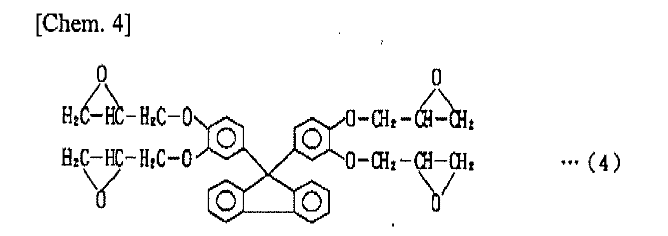

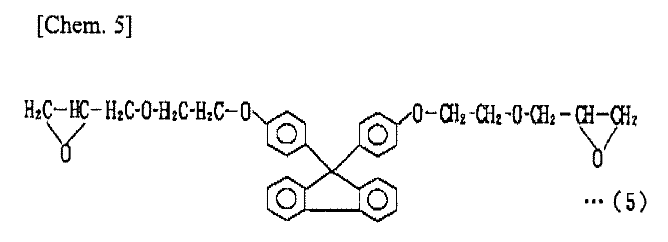

The epoxy compound represented by the above-described chemical formula (3) is bisphenol-fluorene diglycidyl ether (BPFG) and there may be, for example, mentioned ONCOAT EX-1010 and the like manufactured by Nagase & Co., Ltd.

The epoxy compound represented by the above-described chemical formula (4) is bisphenol-fluorene tetraglycidyl ether and there may be, for example, mentioned ONCOAT EX-1040 and the like manufactured by Nagase & Co., Ltd.

The epoxy compound represented by the above-described chemical formula (5) is bisphenoxyethanol-fluorene diglycidyl ether (BPEFG) and there may be, for example, mentioned ONCOAT EX-1020 and the like manufactured by Nagase & Co., Ltd.

In view of flowability and curability of the resin composition, as the epoxy resin of the above-described component (A), the alicyclic epoxy resin is preferably used in combination with the above-described various epoxy resins. In this case, the content of the alicyclic epoxy resin is preferably 50% by weight or less based on the whole epoxy resin of the component (A). As the cyclic epoxy resin, specifically, there may be mentioned 3,4-epoxycyclohexylmethyl-3,4-epoxycyclohexanecarboxylate, a 1,2-epoxy-4-(2-oxiranyl)cyclohexane adduct of 2,2-bis(hydroxymethyl)-1-butanol and the like.

Furthermore, the resin composition for optical components of the invention can contain an oxetane compound as a resin component according to the necessity together with the epoxy resin of the component (A). Examples of the oxetane compound include 3-ethyl-3-phenoxymethyloxetane, bis(3-ethyl-3-oxetanylmethyl) ether, 1,4-bis{[(3-ethyl-3-oxetanyl)methoxy]methyl}benzene, di[2-(3-oxetanyl)butyl] ether, 3-ethyl-3-hydroxymethyloxetane, 1,4-bis[(3-ethyloxetan-3-yl)methoxy]benzene, 1,3-bis[(3-ethyloxetan-3-yl)methoxy]benzene, 1,2-bis[(3-ethyloxetan-3-yl)methoxy]benzene, 4,4'-bis[(3-ethyloxetan-3-yl)methoxy]biphenyl, 2,2'-bis[(3-ethyl-3-oxetanyl)methoxy]biphenyl, 3,3',5,5'-tetramethyl[4,4'-bis(3-ethyloxetan-3-yl)methoxy]biphenyl, 2,7-bis[(3-ethyloxetan-3-yl)methoxy]naphthalene, 1,6-bis[(3-ethyloxetan-3-yl)methoxy]-2,2,3,3,4,4,5,5-octafluorohexane, 3(4),8(9)-bis[(1-ethyl-3-oxetanyl)methoxymethyl]-tncyclo[5.2.1.2.6]decane, 1,2-bis{[2-(1-ethyl-3-oxetanyl)methoxy]ethylthio}ethane, 4,4'-bis[(1-ethyl-3-oxetanyl)methyl]thiodibenzene thioether, 2,3-bis[(3-ethyloxetan-3-yl)methoxymethyl]norbomane, 2-ethyl-2-[(3-ethyloxetan-3-yl)methoxymethyl]-1,3-O-bis[(1-ethyl-3-oxetanyl)methyl]-propane-1,3-diol, 2,2-dimethyl-1,3-O-bis[(3-ethyloxetan-3-yl)methyl]-propane-1,3-diol, 2-butyl-2-ethyl-1,3-O-bxs[(3-ethyloxetan-3-yl)methyl]-propane-1,3-diol, 1,4-O-bis[(3-ethyloxetan-3-yl)methyl]-butane-1,4-diol, and 2,4,6-O-tris[(3-ethyloxetan-3-yl)methyl]cyanuric acid. These compounds are used alone or in combination thereof. Of these, since the curability (curing rate, mechanical strength, etc.) of the resin composition can be further increased by an ultraviolet ray, 3-ethyl-3-phenoxymethyloxetane [the following chemical formula (1)] and bis(3-ethyl-3-oxetanylmethyl) ether [the following chemical formula (2)] are preferred.

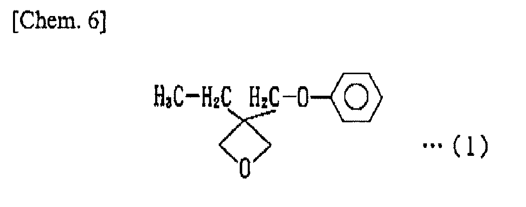

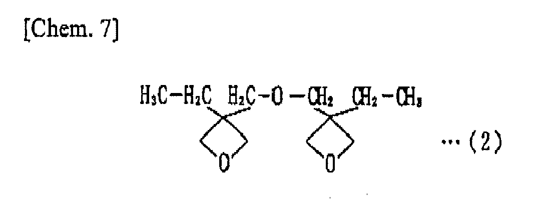

In view of curability, heat discoloration resistance, and the like, the content of the above-described oxetane compound is in the range of preferably 5 to 40% by weight, more preferably 10 to 35% by weight, and further preferably 20 to 30% by weight based on the total amount of the oxetane compound and the epoxy resin of the component (A). That is, when the content of the oxetane compound is less than the above range, a sufficient curability may not be obtained. To the contrary, when the content exceeds the above range, heat resistance may decrease.

Moreover, the content of the "epoxy resin having two or more epoxy groups in one molecule thereof and having a fluorene skeleton" in the epoxy resin of the component (A) is preferably in the range of 10 to 50% by weight based on the total resin amount (total amount of the epoxy resin, the oxetane compound, and the like) in the resin composition. By setting the content to such a range, an objective refractive index (a high refractive index of 1.58 or more) can be obtained.

As the photo-cationic polymerization initiator (photo-acid generator) used in combination with the epoxy resin of the component (A), an onium salt [component (B)] containing hexafluorophosphate ion (PF₆⁻) as an anion component is used as described above.

As described above, the onium salt of the component (B) may be one containing hexafluorophosphate ion as an anion component and examples thereof include a diazonium salt, a sulfonium salt, an iodonium salt, a selenium salt, a pyridinium salt, a ferrocenium salt, and a phosphonium salt. These salts are used alone or in combination thereof. Of these, in view of an anion-forming rate, an aromatic sulfonium salt is preferred. Also, from this viewpoint, particularly preferred is a triarylsulfonium salt.

From the viewpoint of advantageously controlling curability and heat discoloration resistance, the content of the onium salt of the component (B) is set preferably to a range of 0.5 to 4 parts by weight (hereinafter simply referred to as "parts"), particularly preferably to a range of 1 to 3 parts based on 100 parts of the total resin amount in the resin composition.

Incidentally, in the resin composition for optical components of the invention, in addition to the above-described components, a photosensitizer having anthracene, phenanthrene, carbazole, naphthalene, or the like, a silane-based or titanium-based adhesion promoter, a flexibility enhancing agent such as synthetic rubber or polyorganosiloxane, an antioxidant, a defoaming agent, a hydrocarbon-based wax, an inorganic filler, and the like can be appropriately blended, according to the necessity.

The resin composition obtained by mixing the above-described components in a predetermined ratio is formed into a sheet or is filled in a forming mold and then is cured by ultraviolet irradiation, whereby the optical component of the invention can be obtained. Incidentally, after the ultraviolet irradiation, a heat treatment may be performed according to the necessity.

For example, in the case of producing an optical lens, the production is specifically performed as follows. That is, as shown in Fig. 1A, the resin composition 1 is potted (resin potting) on a substrate 12, and a lens shape-forming mold 13 is pressed thereon, whereby as shown in Fig. 1B, the resin composition 1 is filled into the forming mold 13. Thereafter, as shown in Fig. 1C, the resin composition 1 is cured by irradiation with an ultraviolet ray 15 through the forming mold 13 and then, as shown in Fig. 1D, the cured product 11' is demolded and appropriately heat-treated, whereby an optical lens 11 shown in Fig. 2 is obtained. Incidentally, in the case of performing the heat treatment, the cured product of the resin composition after the ultraviolet irradiation may be subjected to the heat treatment before or after demolding the cured product of the resin composition from the forming mold. The optical lens 11 can be produced as a high-quality hybrid lens by integrating it with the substrate 12 (the substrate 12 is appropriately cut to match the size of the optical lens 11). Also, in the case of using the optical lens 11 by removing it from the substrate 12, a release sheet is used as the substrate 12.

As the lens sbape-forming mold 13, for example, a metal-made, glass-made or plastic-made mold may be used. However, as shown in Fig. 1, in the case of curing the resin composition 1 by ultraviolet irradiation through the lens shape-forming mold 13, a glass-made or transparent resin-made ultraviolet-transmitting shape-forming mold is used. Above all, in view of productivity and durability, a glass-made or transparent silicone resin-made shape-forming mold is preferred.

Also, as shown in Fig. 1, in the case of using a substrate 12, as the material therefor, a transparent material having high heat resistant is preferably used because of its adaptability to ultraviolet irradiation (ultraviolet transmittance) or heat treatment. In the case where the substrate 12 has transparency, since ultraviolet irradiation on the resin composition can be performed not only through the forming mold 13 but also through the substrate 12, the latitude of ultraviolet irradiation increases. Furthermore, in the case where the substrate 12 is composed of, for example, various glass materials such as quartz glass, Pyrex (registered trademark) glass and BK-7 (manufactured by SCHOTT GLAS) or a plastic material that is transparent and is not softened at the reflow temperature (around 260°C) (e.g., polyimide resin, silicone resin), the substrate 12 exhibits high adherence to the resin composition 1 and is free from discoloration or deformation, due to heat during solder reflow, Therefore, the optical lens can be produced as a high-quality hybrid lens by integrating the substrate 12 with the cured product (optical lens 11) of the resin composition 1. On the other hand, in the case where the cured product (optical lens 11) obtained by curing the resin composition 1 on the substrate 12 is removed from the substrate 12 and used as an optical lens, in view of transparency or the like, a release sheet such as PET film, PP film, PTFE film or ETFE film is suitably used as the substrate 12.

A mercury lamp can be used as the light source for the ultraviolet irradiation, and the irradiation may be appropriately selected according to the intended thickness of the optical lens. For example, for obtaining a molded product (optical lens) of 300 µm in thickness, the resin composition is preferably irradiated at an irradiation energy of 2,000 to 20,000 mJ/cm², more preferably 3,000 to 15,000 mJ/cm², from the viewpoint of successfully performing its ultraviolet curing. When the ultraviolet irradiation energy is less than the above range, the cured product (optical lens 11) of the resin composition 1 may be separated from the substrate 12 at the removal of the shape-forming mold after ultraviolet irradiation and integrated with the forming mold 13. To the contrary, when the ultraviolet irradiation energy exceeds the above range, ultraviolet deterioration may occur in the cured product (optical lens 11) of the resin composition 1 to cause serious coloration by a subsequent heat treatment.

Moreover, a heat treatment is preferably performed after the ultraviolet irradiation, because the glass transition temperature of the cured product as determined by the dynamic viscoelasticity measurement can reach the desired glass transition temperature. As for the conditions of the heat treatment, in view of productivity, the heat treatment is preferably performed at 80 to 120°C for about 1 hour.

The optical lens is, for example, as shown in Fig. 2, the cured product (optical lens 11) of the ultraviolet-curable transparent resin composition on the substrate 12, which is formed in an arbitrary three-dimensional shape such as columnar shape, cylindrical shape, semispherical shape, pyramidal shape or Fresnel structure. As described above, according to the material of the substrate 12, a hybrid lens may be produced by integrating the substrate with the resin cured product (optical lens 11), or the resin cured product per se may be used as the optical lens by removing the resin cured product (optical lens 11) from the substrate 12. Incidentally, the surface of the optical lens is coated with an antireflection coat material, according to the necessity.

The glass transition temperature of the optical component (resin cured product) of the invention including the above-described optical lens is, in view of temperature cyclability and heat resistance, preferably 100°C or more, more preferably 120°C or more. When the glass transition temperature is less than 100°C, the amount of thermal contraction due to temperature cycle is increased and mismatch of the thermal expansion coefficient with the antireflection coat material may cause separation or cracking of the antireflection coat material.

The optical component of the invention is not discolored or deformed even by the heat during solder reflow and has stable mechanical properties to thermal stress and therefore, is advantageously usable when mounting an imaging device en bloc by solder reflow.

### EXAMPLES

The following will describe Examples together with Comparative Examples. However, the present invention is not limited to these Examples.

First, prior to Examples, the following epoxy resins, oxetane compounds, and photo-acid generators were prepared.

### Epoxy Resin

(a) Bisphenol A-type epoxy resin ("EPIKOTE 827" trade name, manufactured by Japan Epoxy Resins Co., Ltd.)
(b) Hydrogenated bisphenol A-type epoxy resin ("EPIKOTE YX-8000" trade name, manufactured by Japan Epoxy Resins Co., Ltd.)
(c) Fluorene-type epoxy resin ("ONCOAT EX-1020", trade name, manufactured by Nagase & Co., Ltd.)
(d) Fluorene-type epoxy resin ("ONCOAT EX-1040", trade name, manufactured by Nagase & Co., Ltd.)
(e) Alicyclic epoxy resin ("CELLOXIDE 2021P", trade name, manufactured by Daicel Chemical Co., Ltd.)

### Oxetane Compound

(a) 3-emyl-3-phenoxymethyloxetane ("ARON OXETANE OXT-211", trade name, manufactured by Toagosei Co., Ltd.)
(b) Bis(3-ethyl-3-oxetanylmethyl) ether ("ARON OXETANE OXT-221", trade name, manufactured by Toagosei Co., Ltd.)

### Photo-Acid Generator

(a) A triarylsulfonium salt of hexafluorophosphate ion ("UVI-6992", trade name, manufactured by Dow Chemical Co., Ltd.)
(b) A triarylsulfonium salt of hexafluorophosphate ion ("CPI-100P", trade name, manufactured by SAN-APRO Ltd.)
(c) A triarylsulfonium salt of hexafluorophosphate ion ("Escure 1064", trade name, manufactured by DKSH Japan K.K.)
(d) A triarylsulfonium salt of hexafluoroantimonate ion ("CPI-101A", trade name, manufactured by SAN-APRO Ltd.)
(e) A triarylsulfonium salt of hexafluoroantimonate ion ("SP-170", trade name, manufactured by ADEKA Ltd.)

### Examples 1 to 13 and Comparative Examples 1 to 4

The above-described respective components were blended in a ratio shown in Tables 1 and 2 below and heat-melted and mixed to obtain objective resin compositions (one-component ultraviolet-curable transparent resin compositions).

The thus obtained resin compositions were evaluated for properties according to the following criteria. The results are shown together in Tables 1 and 2 below.

### Transparency

Each resin composition (ultraviolet-curable transparent resin composition) prepared above was potted on a Pyrex (registered trademark) glass substrate having a size of 2.5 cm×3.5 cm×500 µm in thickness. Then, a transparent silicone resin-made forming mold having a cavity of a size of 2 cm×3 cm×600 µm in depth was pressed onto the above glass substrate through the above resin composition. After the resin composition was filled into the cavity of the forming mold as above, the resin composition was irradiated with an ultraviolet ray at 30 mW for 500 seconds (amount of ultraviolet ray: 15,000 mJ/cm²) to cure the resin composition. Then, the forming mold was removed (demolded), whereby a resin molded product (test piece) having a size of 2 cm×3 cm×600 µm in thickness was obtained on the above glass substrate (see Fig. 1).

Then, a coloration degree of the thus obtained test piece after post-curing of 100°C×1 hour and after reflow of 260°C×10 seconds was evaluated by measuring the yellow index value (Y.I. value) using a color meter (SM-T, manufactured by Suga Test Instruments Co., Ltd.). That is, those showing the Y.I. value of less than 10 were judged as "Good products" and those showing the Y.I. value of larger than or equal to 10 were judged as "Bad products."

**Table 1**

| | | | Example | | | | | | | | | |
|---|---|---|---|---|---|---|---|---|---|---|---|---|
| | | | 1 | 2 | 3 | 4 | 5 | 6 | 7 | 8 | 9 | 10 |
| Epoxy resin | | a | 50 | 70 | - | - | - | - | - | - | - | - |
| | | b | - | - | 50 | 40 | 40 | - | - | - | - | - |
| | | c | - | - | - | - | - | 35 | - | 50 | - | - |
| | | d | - | - | - | - | - | - | 35 | - | 35 | 35 |
| | | e | 50 | 30 | 50 | 40 | 40 | 35 | 35 | 30 | 35 | 35 |
| Oxetane | | a | - | - | - | 20 | - | 30 | 30 | 20 | 30 | 30 |
| | | b | - | - | - | - | 20 | - | - | - | - | - |
| oto-acid generator | | a | 2 | 2 | 2 | 2 | 2 | 2 | 2 | 2 | - | - |
| | | b | - | - | - | - | - | - | - | - | 2 | - |
| | | c | - | - | - | - | - | - | - | - | - | 2 |
| | | d | | - | - | - | - | - | - | - | - | - |
| | | e | - | - | - | - | - | - | - | - | - | - |
| Transparency | After heat-curing (Y.1, value) | | 4.4 | 4.1 | 3.8 | 2.8 | 3.2 | 3.4 | 3.5 | 3.9 | 3.5 | 3.3 |
| | After reflow (Y.I. value) | | 6.8 | 5.7 | 5.3 | 3.4 | 3.9 | 4.8 | 5.7 | 5.6 | 5.2 | 4.9 |

| | | | | | | | | | | | | |
|---|---|---|---|---|---|---|---|---|---|---|---|---|
| (unit: parts by weight) | | | | | | | | | | | | |

**Table 2**

| | | | Example | | | Comparative Example | | | |
|---|---|---|---|---|---|---|---|---|---|
| | | | 11 | 12 | 13 | 1 | 2 | 3 | 4 |
| Epoxy resin | | a | - | - | - | 50 | 50 | - | - |
| | | b | - | - | - | - | - | - | - |
| | | c | - | 10 | - | - | - | - | - |
| | | d | 35 | - | 35 | - | - | 35 | 35 |
| | | e | 35 | 60 | 35 | 50 | 50 | 35 | 35 |
| Oxetane | | a | 30 | 30 | 30 | - | - | 30 | 30 |
| | | b | - | - | - | - | - | - | - |
| Photo-acid generator | | a | 4 | 4 | 0.5 | - | - | - | - |
| | | b | - | - | - | - | - | - | - |
| | | c | - | - | - | - | - | - | - |
| | | d | - | - | - | 2 | - | 2 | - |
| | | e | - | - | - | - | 2 | - | 2 |
| Transparency | After heat-curing (Y.I. value) | | 6.8 | 4.8 | 2.2 | 24 | 19 | 39 | 35 |
| | After reflow (Y.I. value) | | 8.6 | 5.2 | 3.1 | 28 | 24 | 29 | 22 |

| | | | | | | | | | |
|---|---|---|---|---|---|---|---|---|---|
| (unit: parts by weight) | | | | | | | | | |

As is apparent from the results of the above Tables, in all Examples, there are obtained results that Y.I. values are suppressed to low values as compared with Comparative Examples, after post-curing or after reflow. Therefore, by the use of the resin composition, it becomes possible to provide an optical lens excellent in transparency and heat discoloration resistance. Moreover, an optical component obtained by using the resin composition is free from discoloration even due to heat during solder reflow and has mechanical properties stable to thermal stress and therefore, can be advantageously used when mounting an imaging device en bloc by solder reflow.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2009-116727 filed on May 13, 2009, and the contents are incorporated herein by reference.
Also, all the references cited herein are incorporated as a whole.

According to the resin composition for optical components of the present invention, it is possible to obtain high adherence to glass or the like, high transparency and heat resistance reliability (heat discoloration resistance, thermal contraction resistance, etc.). Also, the optical component obtained by using such a resin composition has mechanical properties stable to thermal stress without causing discoloration or deformation due to heat during solder reflow as described above and therefore can be advantageously used when mounting an imaging device en bloc by solder reflow.

### Description of Reference Numerals and Signs

11 Optical lens
12 Substrate

## Claims

1. A resin composition for optical components, said resin composition being an ultraviolet-curable transparent resin composition to be used as a material for an optical component,
wherein the resin component comprises the following component (A) as a main component and the following component (B) being a photo-cationic polymerization initiator:
(A) an epoxy resin having two or more epoxy groups in one molecule thereof; and
(B) an onium salt containing a hexafluorophosphate ion as an anion component.

2. The resin composition for optical components according to claim 1, wherein the component (A) contains an epoxy resin having a fluorene skeleton.

3. The resin composition for optical components according to claim 2, wherein the epoxy resin having two or more epoxy groups in one molecule thereof and having a fluorene skeleton is contained in an amount ranging from 10 to 50% by weight based on a total resin amount in the resin composition.

4. The resin composition for optical components according to any one of claims 1 to 3, wherein the component (A) contains an alicyclic epoxy resin.

5. The resin composition for optical components according to any one of claims 1 to 4, which contains at least one of oxetane compounds represented by the following chemical formulae (1) and (2) in addition to the components (A) and (B).

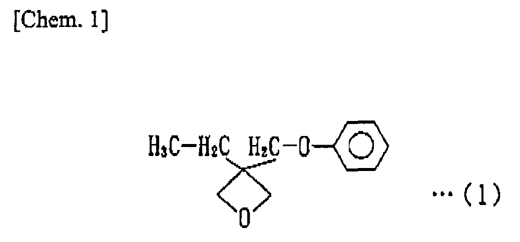

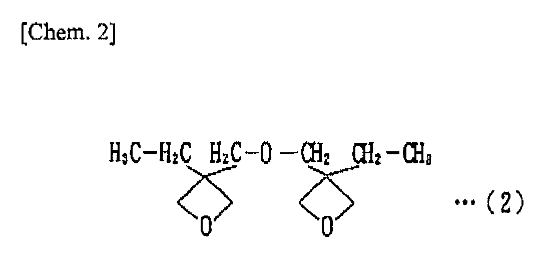

6. The resin composition for optical components according to any one of claims 1 to 5, wherein the component (B) is contained in an amount ranging from 0.5 to 4 parts by weight based on 100 parts by weight of the total resin amount in the resin composition.

7. An optical component obtained by using the resin composition for optical components according to any one of claims 1 to 6.
